# EUROPEAN PATENT APPLICATION

(11) **EP 1 160 212 A1**
(43) Date of publication of application: **05.12.2001**
(21) Application number: 01112803.0
(22) Date of filing: 29.05.2001
(51) Int. Cl.: C03C 11/00, C03C 3/083, C03C 3/091

(54) **Hollow glass microspheres and method for producing the same**

(30) Priority: 31.05.2000 JP 2000163352; 10.07.2000 JP 2000208295
(71) Applicant: Asahi Glass Co., Ltd., Tokyo 100-8405 (JP)
(72) Inventor: Matsubara, Toshiya, Ichihara-shi, Chiba (JP); Tanaka, Masaharu, Ichihara-shi, Chiba (JP); Kusaka, Makoto, Ichihara-shi, Chiba (JP); Yamada, Kenji, Ichihara-shi, Chiba (JP); Nakao, Yasumasa, Kanagawa-ku, Yokohama-shi, Kanagawa (JP)
(74) Representative: Müller-Boré & Partner Patentanwälte

(57) **Abstract**

A hollow glass microsphere having an average particle size of at most 15 µm based on volume, a maximum particle size of at most 30 µm and an average particle density of from 0.1 to 1.5 g/cm³, which has a glass composition consisting essentially of the following components by mass%:

| | |
|---|---|
| SiO₂ | 50.0-90.0%, |
| Al₂O₃ | 10.0-50.0%, |
| B₂O₃ | 0-12.0%, |
| Na₂O+K₂O+Li₂O | 0-1.0%, |
| CaO | 0-10.0%, |
| MgO | 0-10.0%, |
| BaO+SrO | 0-30.0%. |

## Description

The present invention relates to a hollow aluminosilicate glass microsphere comprising a glass composition containing no or substantially no alkali metal and having substantially no eluted amount of boron, and a method for producing the same.

A hollow glass microsphere is generally called as a glass microbaloon (hollow body), and has low specific gravity, satisfactory heat resistance, heat insulating properties, pressure resistance and impact resistance, and achieves physical property-improving effects in respect of size stability and moldability, as compared with conventional fillers. Therefore, this is used for lightening uses such as molding parts including a molding compound for electric household appliances, portable electronic devices and automobiles, a putty, a sealing material, a buoyancy material for ships, a synthetic wood, a reinforcing cement outer wall material, a light weight outer wall material, an artificial marble, and the like. Also, due to the structure of hollow particles, hollow glass microspheres have an effect of providing a low dielectric constant, and is a material expected to be used in the field of a multilayer print substrate, an electric wire coating material or the like, which requires a low dielectric constant.

As mentioned above, hollow glass microspheres have various uses, but recently it is strongly demanded to provide more satisfactory hollow glass microspheres.

Various proposals have been made for hollow glass microspheres and their production methods.

For example, JP-A-58-156551 discloses a method which comprises melting starting materials of SiO₂, H₃BO₃, CaCO₃, Na₂CO₃, NH₄H₂PO₄, Na₂SO₄ and the like at a high temperature of at least 1,000°C to form a glass containing a large amount of a sulfur component, dry-pulverizing the glass, dispersing and staying a classified glass fine powder in flame to foam the glass powder by using the sulfur component as a foaming agent, thereby forming hollow glass microspheres of borosilicate type glass. The hollow glass spheres obtained by this method have a particle density of at most 0.50 g/cm³ as physical properties, but are large spheres having an average particle size of about 50 µm.

Also, JP-B-4-37017 discloses a process for obtaining hollow glass microspheres by calcination in a furnace a fine powder having glass-forming components and a foaming agent component supported by silica gel. The hollow glass microspheres obtained by this process have physical properties including a particle density of about 0.3 g/cm³, and their average particle size is about 70 µm.

However, the hollow glass microspheres obtained by such processes have a sufficient hollow degree to provide a lightening effect, a heat-insulating effect or the like, but their average particle size is at least about 50 µm, and they contain particles having a maximum particle size exceeding 100 µm. Therefore, they can not be used for use of requiring a smooth surface, use of requiring a low dielectric constant, and use of requiring a composite material having a restricted thickness.

Generally, when a particle size distribution becomes wide, a particle density of each particle tends to cause a density distribution, and since large particles having a relatively low particle density have a low particle strength, they are easily broken by an excessive stress applied during a processing step including kneading. Therefore, for example, when used as a filler for a thermoplastic resin, satisfactory aimed effects including a lightening effect, a heat-shielding effect and a low dielectric constant-providing effect can not be obtained.

In order to solve these problems, the present inventors previously developed hollow aluminosilicate glass microspheres having a small particle size, a low density, a high sphericity, a high strength and a high heat resistance. These microspheres provide aimed satisfactory performances, but as a result of studying and developing uses, it has been discovered that bonding with resin is not satisfactory in some uses when they are blended with resin. Also, in some fields of electronic materials, and it is therefore demanded to provide hollow glass microspheres, an eluted amount of boron of which is very small.

As a result of further study for solving such a problem, the present inventors have discovered that glass components of hollow glass microspheres generally include an alkali metal oxide such as Na₂O, K₂O or Li₂O as a reticulation-modifying component of glass, that when an amount of the alkali component becomes larger, chemical resistance is reduced, and consequently that a part of the alkali component is eluted to reduce adhesiveness with matrix resin and to deteriorate electrical resistance properties. In order to solve these problems, the present inventors have proposed to form a protective film on the surface of glass microspheres to prevent the alkali component from eluting.

An object of the present invention is to provide hollow glass microspheres achieving a satisfactory lightening effect, a heat-insulating effect and a low dielectric constant-providing effect depending on their uses, which satisfy requirements of solving the above problems, providing a small particle size, a low density and an excellent chemical resistance, providing no substantial eluted amount of boron and providing a satisfactory adhesiveness with resin and which can be quite suitably used for uses of requiring a smooth surface and a low dielectric constant and also for uses of requiring a composite material having a restricted thickness, and another object of the present invention is to provide a process for efficiently producing such hollow glass microspheres.

Thus, the present invention provides hollow glass microspheres having an average particle size of at most 15 µm based on volume, a maximum particle size of at most 30 µm and an average particle density of from 0.1 to 1.5 g/cm³, which have a glass composition consisting essentially of the following glass components by mass%:

| | |
|---|---|
| SiO₂ | 50.0-90.0%, |
| Al₂O₃ | 10.0-50.0%, |
| B₂O₃ | 0-12.0%, |
| Na₂O+K₂O+Li₂O | 0-1.0%, |
| CaO | 0-10.0%, |
| MgO | 0-10.0%, |
| BaO+SrO | 0-30.0%. |

Also, the present invention provides hollow glass microspheres, wherein a boron concentration in the glass composition is at least 3 mass% as B₂O₃ and an eluted amount of boron measured by the following method is at most 300 ppm of a sample mass amount:

Method for measuring an eluted amount of boron: 200 cm³ of ethanol and 200 cm³ of distilled water are added to 12.5 g of a sample, and the resultant mixture was stirred at 80°C for 1 hour, and a solid content is filtrated, and a boron amount dissolved in the filtrate is determined, and an eluted amount is expressed by a proportion to a sample mass amount.

Thus, the hollow glass microspheres of the present invention are particles having a small particle size and a low density.

The particle size is at most 15 µm as an average particle size based on volume and at most 30 µm as a maximum particle size.

If the average particle size exceeds 15 µm or the maximum particle size exceeds 30 µm, a smooth surface can not be obtained and degradation of outer appearance and deterioration of various properties are unpreferably caused due to the presence of concavo-convex parts when they are used as SMC for an outer plate of an automobile, a filler for a paint or the like. Also, when they are used as an insulating layer material for a multilayer substrate, a filler for a resist material or the like, they are not fixed within a predetermined layer thickness and they tend to cause various inconveniences including a short circuit in a conductive part or the like.

Also, a preferable average particle size is at most 10 µm, and a preferable maximum particle size is at most 20 µm. In the present invention, an average particle size based on volume and a maximum particle size can be measured by a laser scattering type particle size measuring apparatus.

Next, a particle density is from 0.1 to 1.5 g/cm³ as an average particle density. If the particle density is within the range of from 0.1 to 1.5 g/cm³, a satisfactory hollow degree for achieving a low dielectric constant effect, a lightening effect and a heat insulating effect can be provided, and the hollow glass microspheres can be quite suitably useful for use of requiring a smooth surface and use of requiring a composite material having a restricted thickness. Further, a preferable average particle density is from 0.1 to 1.0 g/cm³. In the present invention, the average particle density can be measured by a dry system automatic densimeter.

The hollow glass microspheres of the present invention have a satisfactory particle strength, and for example, hollow glass microspheres having a particle density of 0.60 g/cm³ have a fracture strength of at least 50 MPa at the time when 10% volume is reduced based on volume under hydrostatic pressure. For instance, the hollow glass microspheres have such a sufficient strength as not to be fractured at the time of preparing a compound or during injection molding when they are used as a filler for a thermoplastic resin.

Also, the hollow microspheres of the present invention comprise a substantially spherical single foamed sphere, and according to visual observation by a scanning type electron microscope photograph, the hollow microspheres obtained have a smooth surface and substantially no fractured hollow microspheres are recognized.

The hollow glass microspheres of the present invention consist essentially of an aluminosilicate glass of a glass composition (by mass%) consisting essentially of 50.0-90.0% of SiO₂, 10.0-50.0% of Al₂O₃, 0-12.0% of B₂O₃, 0-1.0% of Na₂O+K₂O+Li₂O, 0-10.0% of CaO, 0-10.0% of MgO, and 0-30.0% of BaO+SrO.

The reasons for restricting the respective components are described below. If SiO₂ is less than 50.0%, the chemical durability of glass tends to be poor, and on the other hand, if it exceeds 90.0%, the viscosity of glass tends to be high, and high calorie will be unfavorably required at the time of foaming. If Al₂O₃ is less than 10.0%, the chemical durability of glass tends to be unfavorably poor, and on the other hand, if it exceeds 50.0%, the melting property tends to be unfavorably poor. A preferable range of Al₂O₃ is from 10 to 25% and a preferable range of SiO₂ is from 50 to 75%.

If B₂O₃ exceeds 12.0%, the chemical durability of glass tends to be unfavorably lowered. Thus, a preferable range of B₂O₃ is from 0 to 10.0%. If CaO exceeds 10.0%, devitrification of glass is unfavorably caused. A preferable range of CaO is from 2.0 to 8.0%. If MgO exceeds 10.0%, devitrification of glass is unfavorably caused. A preferable range of MgO is from 2.0 to 8.0%. Further, BaO and SrO have the same function as CaO and MgO, and if BaO+SrO exceeds 30.0%, devitrification of glass is caused. A preferable range of BaO+SrO is from 5.0 to 25.0%.

The amount of an alkali metal oxide is necessary to be from 0 to 1.0% as a total amount of Na₂O+K₂O+Li₂O, and their preferable range is from 0 to 0.5%. Even if the total amount of Na₂O+K₂O+Li₂O is such a small amount as a few percent, elution of alkali is caused, and it lowers electric insulating properties and causes various inconveniences such as lowering of adhesiveness with matrix resin depending on a resin used. Therefore, it is necessary to restrict the total amount of Na₂O+K₂O+Li₂O to at most 1.0%. Thus, by restricting the total amount of Na₂O+K₂O+Li₂O to such a small amount, the hollow glass microspheres can be used without any surface treatment as they are.

In addition to the above components, amounts of other components such as P₂O₅, Fe₂O₃, TiO₂ and the like are preferably restricted to an amount as small as possible in view of maintaining satisfactory heat resistance and strength although the amounts of these components are not particularly limited. Usually, the amounts of these components are preferably at most 2.0%.

In present invention, various methods can be employed as a method for obtaining hollow glass microspheres containing a B₂O₃ component in an amount of at least 3% but an eluted amount of boron being restricted to a very small amount of at most 300 ppm, depending on the content of the B₂O₃ component and an aimed elution amount of boron.

For example, it is possible to improve the method for producing hollow glass microspheres itself, or the hollow glass microspheres obtained may be subjected to a post treatment (e.g. solid-liquid separation, classification treatment, washing treatment, special de-boron treatment or a combination thereof).

The hollow glass microspheres of the present invention are useful for the following uses. That is, when they are used as a filler for a resist material, a layer insulation material of a multilayer print substrate or the like, they provide excellent high frequency properties due to effects achieved by lowering a dielectric constant and lowering a dielectric dissipation factor, and also provide a high electric insulating property. Also, they can be widely used for use of restricting a thickness of a composite material. Particularly, since they cause no problems in bonding with resin, they provide a molded product of resin having a very smooth surface and a satisfactory adhesiveness when used as a filler for resin, and since they have a sufficient particle strength and are hardly fractured during processing, a desired lightening effect and/or a heat-shielding effect can be achieved.

Also, the hollow glass microspheres of the present invention are not limited for the above-mentioned uses, but can be quite suitably used in various fields and uses such as a lightening filler for cement, mortal, synthetic wood, a low melting metal including aluminum or magnesium or their alloys and paints, a heat-shielding and lightening filler for a building material and a latex, a filler for sensitizing an explosive compound, an electric insulating layer filler, a sound-proofing filler, a cosmetics filler, a filtrating material, a blast media, a spacer, and the like. Also, if they are used in a mixture with hollow glass spheres having a larger particle size of at least 20 µm, the hollow glass microspheres of the present invention can be filled in gaps between larger particles and can achieve more satisfactory effects of lowering a dielectric constant, lightening and heat-shielding.

Also, examples of resins to which the hollow glass microspheres of the present invention are added as a filler, include epoxy resin, phenol resin, furan resin, unsaturated polyester resin, xylene resin, alkyd resin, melamine resin, polyethylene resin, polypropylene resin, polyvinyl chloride resin, polyvinylidene chloride resin, polyvinyl acetate resin, polyimide resin, polyamide resin, polyamideimide resin, polycarbonate resin, methacrylic resin, ABS resin, fluorine resin, and the like.

Hereinafter, a process for producing the hollow glass microspheres of the present invention is described. In the present invention, glass starting materials are formed into glass by heating, and various starting materials can be used for forming a desired glass composition and glass starting materials contain a foaming component. The foaming component generates gas when the glass starting materials are formed into glass spheres by heating, and has a function of forming a melted glass into a hollow glass sphere.

A foaming component preferably contains at least one material of generating water vapor, carbonic acid gas, sulfur oxide gas or nitrogen oxide gas by heating.

These starting materials are formed into hollow glass microspheres by blending the starting materials so as to provide a predetermined composition, wet-pulverizing the starting materials in a combustible liquid such as alcohol, kerosine, gas oil, heavy oil or the like to prepare a slurry containing starting material powders having an average particle size of at most 3.0 µm, particularly at most 2.0 µm, forming the slurry into fine liquid droplets containing the starting materials by spraying method or the like, and heating the droplets to produce hollow glass microspheres.

The process for producing the hollow glass microspheres of the present invention is further described in more details hereinafter. Examples of the glass starting materials include various oxides and salts obtained by synthesizing, natural zeolite, natural volcanic glass materials, and the like. Examples of the foaming component which generates water vapor include natural volcanic glass materials such as fluorite, perlite, obsidian or volcanic ash, boric acid, synthetic or natural zeolite, silica gel, and the like, which have an ignition loss.

Examples of an inorganic material generating carbonic acid gas, sulfur oxide gas or nitrogen oxide gas include sulfate, carbonate or nitrate of an alkaline earth metal such as CaSO₄, CaCO₃, Ca(NO₃)₂, MgSO₄, MgCO₃, Mg(NO₃)₂, BaSO₄, BaCO₃, Ba(NO₃)₂, SrSO₄, SrCO₃, Sr(NO₃)₂, or the like, carbide or nitride of silicon, carbide or nitride of aluminum, and the like. Further, a substance having a hydrate such as bonding water, which generates steam when heated, can also be used.

These foaming components generating gas by heating are selected depending on properties and functions of aimed hollow glass microspheres. For example, when they are used for electronic parts such as an insulating layer material between layers of a multilayer substrate, a filler for a resist material or the like, it is preferable to use a material generating water vapor and/or carbonic acid gas, which are less corrosive and provide less influence on corrosion even if the hollow glass microspheres are broken and internal gas enclosed therein is released.

For the wet pulverization of the material, as the liquid to be used for the wet pulverization, a combustible liquid is preferred for the subsequent spraying and heating. Among them, it is preferred to use the same material as the liquid for the slurry, since the operation step can be simplified. The combustible liquid may, for example, be an alcohol such as methanol, ethanol or isopropyl alcohol, an ether, kerosine, light oil or heavy oil. This liquid may be a mixture of these combustible liquids, or may contain other liquid such as water.

Further, for the dispersion of the slurry or stabilization of the dispersion, a dispersing agent or a dispersion stabilizer may be added. The dispersing agent may, for example, be a nonionic surfactant, a cationic surfactant, an anionic surfactant or a polymer type surfactant. Among them, a polymer anionic surfactant is preferred. For example, an acid-containing oligomer which is a copolymer of acrylic acid and an acrylate and which has a large acid value such that the acid value is at a level of from 5 to 100 mgKOH/g, is preferred. Such a polymer anionic surfactant is advantageous in that it not only contributes to the dispersion of the slurry and the stabilization of the dispersed state, but also is effective to control the viscosity of the slurry to be low.

With respect to the concentration of the formulated powder material in the liquid in the wet pulverization step, it is preferred to adjust the amount of the liquid so that it becomes the same as the concentration of the glass formulation material in the slurry which is required for spraying, whereby the operation can be simplified.

The wet pulverizer to be used is preferably a medium-stirring mill represented by a beads mill from the viewpoint of the pulverization speed or the final particle size. However, it may be a wet pulverizer such as a ball mill, a grind mill, an ultrasonic pulverizer or a high pressure fluid static mixer. Contamination from the material of the pulverizer may lower the yield or the strength of the hollow glass microspheres depending upon its composition and amount of inclusion. Accordingly, the material of the portion in contact with the liquid, is preferably selected from alumina, zirconia or an alumina/zirconia composite ceramic. Otherwise, it may be a material having a composition similar to the raw material.

The average particle size (based on volume) of the glass formulation material after the wet pulverization is preferably at most 3.0 µm, and if the average particle size exceeds 3.0 µm, it tends to be difficult to obtain hollow glass microspheres having a uniform composition especially when a plurality of materials are mixed or a recycled material removed by classification or flotation is formulated. The average particle size of the glass formulation material after the wet pulverization is more preferably within a range of from 0.01 to 2.0 µm.

In a case where particles having large particle sizes are contained in the wet-pulverized glass formulation material, the material may be classified in a wet state to select the material having a predetermined particle size for use. Even when pulverized to an average particle size of less than 0.01 µm, there will be no problem in the subsequent operation, if the concentration and the viscosity of the slurry are adjusted. However, such is not preferred for a mass production on an industrial scale, since the installation or the power consumption for the pulverization will be excessive.

In a case where the glass formulated material thus obtained does not have a predetermined concentration as a slurry, a liquid corresponding to the deficient amount, is added so that the glass formulation material will have the predetermined concentration. If the concentration of the formulated material in the slurry is too low, the productivity decreases, and if it is too high, the viscosity of the slurry increases, whereby the handling tends to be difficult, and agglomeration is likely to result, whereby hollow glass microspheres tend to have a large particle size. The concentration of the glass formulation material in the slurry is preferably from 5 to 50 mass%, particularly preferably from 10 to 40 mass%.

Then, this slurry is formed into droplets. The droplets contain the glass formulation material. As a method for forming such droplets, a method for forming droplets by spraying under pressure, a method for forming droplets by ultrasonic waves, a method for forming droplets by a centrifugal force, or a method for forming droplets by static electricity, may, for example, be mentioned. However, from the viewpoint of the productivity, it is preferred to employ a method for forming droplets by spraying under pressure. The following two methods may be exemplified as the method for forming droplets by spraying under pressure.

The first method for forming droplets is a method of using a binary fluid nozzle to form droplets under a gas pressure of from 0.1 to 2 MPa. Here, if the gas pressure is less than 0.1 MPa, the action to form fine droplets by blast gas tends to be too low, whereby the particle size of the resulting hollow glass microspheres tends to be too large, and it tends to be difficult to obtain microspheres having the desired particle size. On the other hand, if the gas pressure exceeds 2 MPa, the combustion tends to be instable, and flame off is likely to result, or the installation or the required power for pressurizing tends to be excessive, such being undesirable for industrial operation.

As such a gas, any one of air, nitrogen, oxygen and carbon dioxide may suitably be used. However, with a view to obtaining hollow glass microspheres excellent in the surface smoothness or from the viewpoint of the control of the combustion temperature, the oxygen concentration is preferably at most 30 vol%, whereby the combustion before completion of forming the slurry into droplets in the spray granulation process, is suppressed, and after the formation of droplets is completed and the predetermined droplets are formed, the droplets will be burned. By such a control, the particle size distribution of droplets will be fine and sharp, and consequently, the particle size distribution of microspheres will be fine and sharp, whereby light weight hollow microspheres can be obtained in good yield.

The second method for forming droplets is a method of spraying the slurry by exerting a pressure of from 1 to 8 MPa to the slurry, to form droplets. If this pressure is less than 1 MPa, the particle size of the hollow glass microspheres tends to be too large, whereby it tends to be difficult to obtain microspheres having the desired particle size. On the other hand, if this pressure exceeds 8 MPa, the combustion tends to be instable, and flame off is likely to result, or the installation or the required power for pressurizing tends to be excessive, such being undesirable for industrial operation.

The formed droplets contain the glass formulation material having the desired composition. If the size of such droplets is too large, the combustion tends to be instable, or large particles are likely to form, or the particles are likely to burst during the heating or combustion to form an excessively fine powder, such being undesirable. If the granulated product made of the pulverized powder material is excessively small, the resulting glass composition tends to be hardly uniform, whereby the yield of hollow glass microspheres tends to be low, such being undesirable. A preferred size of droplets is within a range of from 0.1 to 70 µm.

When such droplets are heated, the glass formulation material is melted and vitrified, and further, the foaming component in the glass will be gasified to form hollow glass microspheres. As the heating means, an optional one such as combustion heating, electric heating or induction heating, may be used. The heating temperature depends on the temperature for vitrification of the glass formulation material. Specifically, it is within a range of from 300 to 1,800°C. In the present invention, as the most suitable means, since the liquid component of the slurry is combustible liquid, the melting and foaming of the glass are carried out by the heat generation by the combustion of such a liquid.

The hollow glass microspheres thus formed, are recovered by a known method such as a method using a cyclone, a bag filter, a scrubber or a packed tower. Then, in case a non-foamed product in the recovered powder is removed, only the foamed product is recovered by a flotation separation method by means of water. In a case of selecting a foamed product having a low density, it is effective to employ a flotation method by means of e.g. an alcohol having a low specific gravity.

Since salts which are not involved in hollow glass microspheres have a possibility to lower chemical durability, a water slurry of recovered powder and/or a slurry recovered by a flotation separation method are subjected to centrifugal filtration, filtration under reduced pressure or filtration under pressure to carry out solid-liquid separation, and the salts are removed by washing carried out by continuously supplying a washing water to a filter cake.

Further, a method for removing residual salts and impurities which comprises diluting a filtration cake with water to prepare a slurry again, fully stirring the slurry and repeating a filtration procedure one or several times, is also preferable. Water used for washing is not specially limited, but tap water, ion exchanged water or desalted water is usable in view of washing efficiency. Also, it is preferable to heat water used to a high temperature.

In these procedures of solid-liquid separation, removal of salts and removal of impurities, it is effective to repeatedly carry out these procedures and a washing procedure in order to obtain hollow glass microspheres having substantially no eluted amount of boron.

Also, in order to make the hollow glass microspheres suitable for use of requiring a smooth surface or use of requiring a composite material having a restricted thickness, it is necessary to make a maximum particle size of the hollow glass microspheres less than 30 µm, and if necessary, the hollow glass microspheres are subjected to classification treatment in view of particle size properties of recovered powders. A method of classification treatment is not specially limited, but is preferably an air classifier or a sieve classifier.

In the flotation separation step of the method for producing the hollow glass microspheres of the present invention, it is very effective for obtaining a light product having an average particle density of lower than 1.0 g/cm³ and for improving production efficiency to disperse heat-foamed hollow glass microspheres in water and to separate and remove particles having a density of higher than 1.0 g/cm³ by centrifugal force.

This is because broken microspheres of smaller particle size are hardly separatable simply by mixing with water and allowing a mixture to settle. That is, broken pieces of usual hollow glass spheres are settled and separated by dispersing in water, but broken glass microspheres of smaller particle size are hardly separatable since water hardly enters into the inside of microspheres.

Further, broken bad hollow microspheres can be more completely removed and lightening of a product becomes easier on the same reasons if hollow glass microspheres produced are previously degassed under reduced pressure before dispersing in water or hollow glass microspheres are degassed under reduced pressure after dispersing in water, and then particles having a density of higher than 1.0 g/cm³ are separated and removed by centrifugal force.

According to the present invention, hollow glass microspheres of an aluminosilicate glass composition containing no alkali metal or substantially no alkali metal and having an average particle size of at most 15 µm, a maximum particle size of at most 30 µm and an average particle density of from 0.1 to 1.5 g/cm³, thus having substantially uniform particle size, can be obtained. This is due to a method of building up finely pulverized aluminosilicate glass starting materials and a spraying method of a slurry. According to the method of the present invention, the size of liquid droplets becomes easily uniform, and one liquid droplet forms one hollow glass microsphere, and each liquid droplet is burned to generate a combustion gas, thereby preventing each particle from agglomerating. Also, the hollow glass microspheres comprise a glass composition containing no alkali metal or substantially no alkali metal, and therefore they provide a satisfactory adhesiveness with resin.

### EXAMPLES

### EXAMPLE 1

58.0 g of silicon dioxide, 57.6 g of aluminum sulfate, 14.4 g of boric acid, 6.3 g of magnesium carbonate, 6.5 g of calcium carbonate, 10.8 g of strontium carbonate and 7.7 g of a dispersant (Homogenol L-1820, manufactured by Kao Corporation, hereinafter the same) were mixed in 500 g of kerosine, and the resultant mixture was wet-pulverized by a medium-stirring type mill to obtain a slurry of glass starting materials.

The medium-stirring type mill used, had an internal capacity of 1,400 cm³, and it was made of zirconia as its material. Beads were made of zirconia and had an average diameter of 0.65 mmφ, and 1,120 cm³ of such beads were put and used. The wet-pulverization was carried out at a stirring rotation number of 2,500 rpm for 30 minutes. Glass starting material particles were recovered from the above obtained slurry of glass starting materials, and their average particle size was measured by a laser scattering type particle size measuring apparatus (Microtruck HRA model 9320-X100, manufactured by NIKKISO Co., LTD., hereinafter the same), and the measured average particle size was 1.6 µm based on volume.

A kerosine slurry of glass starting materials thus obtained was made into droplets by a binary fluid nozzle, and the droplets were burned by flaming to obtain hollow glass microspheres. Air was used as a spraying gas used in the binary fluid nozzle, and its pressure was 0.4 MPa, and the droplets thus formed had a size of about 12 µm. A combustion air amount used during burning was 1.25 times amount of a theoretical air amount, and a combustion temperature was about 1,550°C.

The particles thus obtained were recovered by a bag filter, and their shapes were observed by a scanning type electron microscope, and were proved to be sphere-like. The particle size of the recovered particles was measured by a laser scattering type particle size measuring apparatus, and was proved to have an average particle size of 7.1 µm and a maximum particle size of about 17 µm. The maximum particle size measured by a scanning electron microscope was also about 16.5 µm, and the two measured values were substantially the same.

Also, a particle density measured by a dry type automatic densimeter (Acupic 1330, manufactured by Shimadzu Corporation, hereinafter the same) was 0.92 g/cm³. A fracture strength at the time of 10% volume reduction was 75 MPa based on volume under hydrostatic pressure. The obtained particles were subjected to x-ray diffraction analysis, and were proved to be vitreous hollow glass microspheres. Their glass composition was analyzed by chemical analysis method and ICP method, and was proved to have the following composition.

| | |
|---|---|
| SiO₂ | 60.5%, |
| Al₂O₃ | 17.9%, |
| B₂O₃ | 6.7%, |
| MgO | 3.2%, |
| CaO | 3.8%, |
| SrO | 7.9%. |

Thereafter, a resin composition was prepared by blending 30 mass parts of a filler comprising the above obtained hollow glass microspheres with a mixture having 85 mass parts of tetrahydrophthalic anhydride and 1 mass part of an imidazol type curing agent dissolved in 100 mass parts of epoxy resin (Epikote 152, manufactured by Yuka-Shell Company, epoxy equivalent=175, hereinafter the same). The resin composition thus prepared was formed into an epoxy resin cured material by casting method to obtain a sheet-like test piece of 20 cm square having a thickness of 3 mm by cutting.

An electroconductive paste was coated on both sides of the above obtained sheet, and its dielectric constant and dielectric dissipation factor were measured in accordance with Japan Industrial Standard (JIS K6911, hereinafter the same), and were proved to have a dielectric constant of 2.80 and a dielectric dissipation factor of 0.011 under 1 MHz frequency. Further, its insulation resistance was measured in accordance with Japan Industrial Standard (JIS K6911, hereinafter the same), and was 9.3×10¹⁴Ω. Also, the same physical properties were measured with regard to the epoxy resin alone without containing hollow glass microspheres in the same manner as above, and were proved to have a dielectric constant of 3.23, a dielectric dissipation factor of 0.014 and an insulating resistance of 1.8×10¹⁴Ω.

### EXAMPLE 2

Glass starting materials were prepared by mixing 118.1 g of silicon dioxide, 121.0 g of Ca-substituted 4A zeolite (CaO·Al₂O₃·2SiO₂·4.5H₂O), 30.1 g of boric acid, 13.2 g of magnesium carbonate, 18.7 g of strontium carbonate, 16.9 g of barium carbonate and 11.6 g of a dispersant, and were wet-pulverized by a ball mill to obtain a slurry of the glass starting materials.

The ball mill used had an internal capacity of 5,000 cm³, and 2,500 cm³ of alumina-made balls of 10-15 mm φ were placed therein. The above obtained glass starting materials and 1,500 g of kerosine were placed in the ball mill, and were wet-pulverized at 100 rpm for 20 hours to obtain a slurry of the glass starting materials. Glass starting material particles were recovered from the slurry of the glass starting materials thus obtained, and their average particle size was measured by a laser scattering type particle size measuring apparatus and was measured to be 2.0 µm based on volume.

The above obtained kerosine slurry of the glass starting materials was made into liquid droplets by a binary fluid nozzle, and the droplets were burned by flaming to obtain vitreous hollow glass microspheres. Air was used as a spraying gas used in the binary fluid nozzle, and its pressure was 0.35 MPa, and the droplets formed thereby had a size of about 14 µm. A combustion air amount at the time of burning was 1.4 times amount of a theoretical air amount, and a combustion temperature was about 1,400°C.

The particles thus obtained were recovered by a bag filter, and were made into a slurry by mixing with water, and particles having a true density of less than 1.0 g/cm³ floated on water surface were recovered by a centrifugal separation apparatus, and the particles floated on the water surface were classified by a wet type vibrating sieve (manufactured by Dulton Company, hereinafter the same) having a polyester-made net of 25 µm to recover a product classified through the sieve. The product thus recovered was subjected to a filter under reduced pressure to separate a solid material, and was then dried at 120°C to obtain a powder separated through the sieve. All of the particles of the powder thus obtained were proved to have a sphere-like shape by observing with a scanning type electron microscope.

A particle size of the powder was measured by a laser scattering type particle size measuring apparatus, and was proved to have an average particle size of 9.8 µm. Its maximum particle size was about 24 µm according to observation by a scanning electron microscope. Also, a particle density measured by a dry type automatic densimeter was 0.58 g/cm³. A fracture strength at the time of 10% volume reduction was 55 MPa based on volume under hydrostatic pressure. The obtained particles were subjected to x-ray diffraction analysis, and were proved to be vitreous hollow glass microspheres. Its glass composition was analyzed by chemical analysis method and ICP method, and was proved to have the following composition.

| | |
|---|---|
| SiO₂ | 60.7%, |
| Al₂O₃ | 13.1%, |
| B₂O₃ | 6.4%, |
| MgO | 2.4%, |
| CaO | 7.2%, |
| SrO | 5.1%, |
| BaO | 5.1%. |

Thereafter, a resin composition was prepared by blending 19 mass parts of a filler comprising the above obtained hollow glass microspheres with a mixture having 85 mass parts of tetrahydrophthalic anhydride and 1 mass part of an imidazol type curing agent dissolved in 100 mass parts of epoxy resin (Epikote 152). The resin composition thus prepared was formed into an epoxy resin cured material by casting method to obtain a sheet-like test piece of 20 cm square having a thickness of 3 mm by cutting.

An electroconductive paste was coated on both sides of the above obtained sheet, and its dielectric constant and dielectric dissipation factor were measured in accordance with Japan Industrial Standard, and were proved to have a dielectric constant of 2.65 and a dielectric dissipation factor of 0.011 under 1 MHz frequency. Further, its insulation resistance was measured in accordance with Japan Industrial Standard, and was 8.5×10¹⁴Ω. Also, the physical properties were measured with regard to the epoxy resin alone without containing hollow glass microspheres in the same manner as above, and were proved to have a dielectric constant of 3.23, a dielectric dissipation factor of 0.014 and an insulating resistance of 1.9×10¹⁴Ω.

### EXAMPLE 3

A slurry of glass starting materials was obtained by mixing 139.6 g of a glass cullet (composition: SiO₂ 59.5%, Al₂O₃ 17.6%, B₂O₃ 8.3%, MgO 3.1%, CaO 3.7% and SrO 7.8%) having an average particle size of about 10 µm obtained by previously dissolving starting materials and finely pulverizing, 14.0 g of magnesium sulfate and 7.7 g of a dispersant in 500 g of kerosine and wet-pulverizing the resultant mixture by a medium-stirring type mill.

The medium-stirring type mill used had an internal capacity of 1,400 cm³, and it was made of zirconia as its material. Beads were made of zirconia and had an average diameter of 0.65φ, and 1,120 cm³ of such beads were put and used. The operation condition was such that the rotational speed was 2,500 rpm, and the wet pulverization was carried out for 60 minutes. From the obtained slurry of glass starting materials, glass starting material particles were recovered, and their particle size was measured by a laser scattering type particle size measuring apparatus and was proved to have an average particle size of 1.5 µm based on volume.

The above obtained kerosine slurry of the glass starting materials was made into liquid droplets by a binary fluid nozzle, and the droplets were burned by flaming to obtain vitreous hollow glass microspheres. Air was used as a spraying gas used in the binary fluid nozzle, and its pressure was 0.4 MPa, and the droplets formed thereby had a size of about 13 µm. A combustion air amount at the time of burning was 1.7 times amount of a theoretical air amount, and a combustion temperature was about 1,250°C.

The particles thus obtained were recovered by a bag filter, and their shape was observed by a scanning type electron microscope, and all of the particles were proved to be sphere-like. A particle size of the powder recovered was measured by a laser scattering type particle size measuring apparatus, and was proved to have an average particle size of 7.2 µm and a maximum particle size of about 18.5 µm. According to observation by a scanning electron microscope, a maximum particle size was about 19 µm. Thus, the two measured values were substantially the same each other.

Also, their particle density measured by a dry type automatic densimeter was 1.36 g/cm³. A fracture strength at the time of 10% volume reduction was 85 MPa based on volume under hydrostatic pressure, and the obtained particles were subjected to x-ray diffraction analysis, and were proved to be vitreous hollow glass microspheres. The glass composition of the hollow glass microspheres was analyzed by chemical analysis method and ICP method, and was proved to have the following composition.

| | |
|---|---|
| SiO₂ | 59.5%, |
| Al₂O₃ | 17.6%, |
| B₂O₃ | 6.6%, |
| MgO | 4.8%, |
| CaO | 3.7%, |
| SrO | 7.8%. |

Thereafter, a resin composition was obtained by blending 40 mass parts of a filler comprising the above obtained hollow glass microspheres with a mixture having 85 mass parts of tetrahydrophthalic anhydride and 1 mass part of an imidazol type curing agent dissolved in 100 mass parts of epoxy resin (Epikote 152). The resin composition thus obtained was formed into an epoxy resin cured material by casting method to obtain a sheet-like test piece of 20 cm square having a thickness of 3 mm by cutting.

An electroconductive paste was coated on both sides of the above obtained sheet, and its dielectric constant and dielectric dissipation factor were measured in accordance with Japan Industrial Standard, and were proved to have a dielectric constant of 2.95 and a dielectric dissipation factor of 0.012 under 1 MHz frequency. Further, its insulation resistance was measured in accordance with Japan Industrial Standard, and was 9×10¹⁴Ω. Also, the physical properties were measured with regard to the epoxy resin alone without blending hollow glass microspheres in the same manner as above, and were proved to have a dielectric constant of 3.23, a dielectric dissipation factor of 0.014 and an insulating resistance of 1.8×10¹⁴Ω.

### EXAMPLE 4 (COMPARATIVE EXAMPLE)

A slurry of glass starting materials was obtained by mixing 85.0 g of silicon dioxide, 22.5 g of calcium carbonate, 18.2 g of boric acid, 5.0 g of dibasic calcium phosphate, 2.0 g of lithium carbonate, 6.7 g of sodium sulfate, 14.2 g of borax and 7.7 g of a dispersant, and wet-pulverizing the resultant mixture by a ball mill.

The ball mill used had an internal capacity of 5,000 cm³, and 2,500 cm³ of alumina-made balls of 10-15 mm φ were placed therein. Further, the above obtained glass starting materials and 1,500 g of kerosine were placed therein, and the resultant mixture was wet-pulverized at 100 rpm for 20 hours to obtain a slurry of the glass starting materials. Glass starting material particles were recovered from the slurry of the glass starting materials thus obtained, and their average particle size was measured by a laser scattering type particle size measuring apparatus and was proved to have an average particle size of 1.4 µm based on volume.

The above obtained kerosine slurry of the glass starting materials was made into liquid droplets by a binary fluid nozzle, and the droplets were burned by flaming to obtain vitreous hollow glass microspheres. Air was used as a spraying gas used in the binary fluid nozzle, and its pressure was 0.4 MPa, and the droplets formed thereby had a size of about 10 µm. A combustion air amount at the time of burning was 1.4 times amount of a theoretical air amount, and a combustion temperature was about 1,400°C.

The particles thus obtained were recovered by a bag filter, and was formed into a slurry by mixing with water, and particles having a true density of less than 1.0 g/cm³ floated on water surface were recovered by a centrifugal separation apparatus, and the particles floated on the water surface were classified by a wet type vibrating sieve having a polyester-made net of 25 µm, and the product passed through the sieve was recovered. The product was then subjected to a filter under reduced pressure to separate a solid material, which was then dried at 120°C to obtain a powder passed through the sieve. The powder passed through the sieve was observed by a scanning type electron microscope, and was proved to have a sphere-like shape.

A particle size of the powder was measured by a laser scattering type particle size measuring apparatus, and was proved to have an average particle size of 9.5 µm. Its maximum particle size was about 25 µm according to observation by a scanning electron microscope.

Also, a particle density measured by a dry type automatic densimeter was 0.49 g/cm³. A fracture strength at the time of 10% volume reduction was 30 MPa based on volume under hydrostatic pressure. According to x-ray diffraction analysis, the obtained particles were confirmed to be vitreous hollow glass microspheres. The hollow glass microspheres were further analyzed in accordance with chemical analysis method, ICP method and atomic spectrum method, and were proved to have the following composition.

| | |
|---|---|
| SiO₂ | 71.7%, |
| B₂O₃ | 10.4%, |
| CaO | 10.6%, |
| Na₂O | 4.2%, |
| Li₂O | 0.7%, |
| P₂O₅ | 2.4%. |

Thereafter, a resin composition was obtained by blending 19 mass parts of a filler comprising the above obtained hollow glass microspheres with a mixture of 85 mass parts of tetrahydrophthalic anhydride and 1 mass part of an imidazol type curing agent dissolved in 100 mass parts of epoxy resin (Epikote 152). The resin composition thus obtained was formed into an epoxy resin cured material by casting method, which was then cut into a sheet-like test piece of 20 cm square having a thickness of 3 mm.

An electroconductive paste was coated on both sides of the above obtained sheet, and its dielectric constant and dielectric dissipation factor were measured in accordance with Japan Industrial Standard, and were proved to have a dielectric constant of 2.92 and a dielectric dissipation factor of 0.011 under 1 MHz frequency. Further, its insulation resistance was measured in accordance with Japan Industrial Standard, and was 8×10¹²Ω. Thus, the insulating resistance was remarkably lowered. Also, physical properties were measured with regard to the epoxy resin alone without blending hollow glass microspheres in the same manner as above, and were measured to have a dielectric constant of 3.23, a dielectric dissipation factor of 0.014 and an insulating resistance of 1.8×10¹⁴Ω.

### EXAMPLE 5

A slurry of glass starting materials was obtained by mixing 139.6 g of a glass cullet (composition: SiO₂ 59.5%, Al₂O₃ 17.6%, B₂O₃ 8.3%, MgO 3.1%, CaO 3.7% and SrO 7.8%) having an average particle size of about 10 µm obtained by previously dissolving starting materials and finely pulverizing, 14.0 g of magnesium sulfate and 7.7 g of a dispersant (Homogenol L-1820) in 500 g of kerosine and wet-pulverizing the resultant mixture by a medium-stirring type mill.

The medium-stirring type mill and the beads used were the same as those used in Example 1. The operation conditions were such that the rotational speed was 2,500 rpm, and the wet-pulverization was carried out for 60 minutes. Glass starting material particles were recovered from the above obtained slurry of glass starting materials, and their average particle size was measured by a laser scattering type particle size measuring apparatus and was measured to be 1.5 µm.

The above obtained kerosine slurry of the glass starting materials was made into liquid droplets by a binary fluid nozzle, and the droplets were burned by flaming to obtain vitreous hollow glass microspheres. Air was used as a spraying gas used in the binary fluid nozzle, and its pressure was 0.4 MPa, and the droplets formed thereby had a size of about 13 µm. A combustion air amount at the time of burning was 1.7 times amount of a theoretical air amount, and a combustion temperature was about 1,250°C.

The hollow glass microspheres thus obtained were recovered by a bag filter, and were made into a slurry by mixing with water, and the slurry were centrifugally separated to recover particles floating on water surface only as a slurry. The slurry thus obtained was then classified by a wet type vibrating sieve having a stainless steel-made net of 42 µm, and a slurry passed through the sieve was recovered. The slurry thus obtained was subjected to solid-liquid separation, and its filtration cake was formed into a slurry with desalted water at 50°C in an amount of 30 times amount of the solid content, and the resultant slurry was subjected to solid-liquid separation again. This operation was repeated one more time, and a cake obtained was dried by allowing to stand at 120°C to obtain a product floating on water surface. All of the particles of the product floating on the water surface were proved to have a sphere-like shape by observing with a scanning type electron microscope.

A particle size of the product floating on the water surface was measured by a laser scattering type particle size measuring apparatus, and was proved to have an average particle size of 8.5 µm and a maximum particle size of about 20 µm. A maximum particle size observed by a scanning type electron microscope was about 20 µm. Thus, the two measured values were substantially the same each other. A particle density measured by a dry type automatic densimeter was 0.52 g/cm³. The microspheres thus obtained were confirmed to be vitreous by X-ray diffraction analysis. Further, an eluted amount of boron of the above obtained hollow glass microspheres was measured and was proved to be 30 ppm of a sample mass amount. On the other hand, the hollow glass microspheres recovered immediately after a bag filter were measured with regard to an eluted amount of boron in the same manner as above, and the eluted amount of boron thus measured was 650 ppm of a sample mass amount.

A reason why the eluted amount of boron was 30 ppm in this Example, is considered to be due to procedures of slurrying, centrifugal separation and solid-liquid separation treatment. Particularly, this is largely due to an effect of washing treatment of cake at the time of the solid-liquid separation.

### EXAMPLE 6 (COMPARATIVE EXAMPLE)

An eluted amount of boron was measured with regard to tradename HSC-110 (hollow glass beads comprising aluminosilicate containing 7.9% of B₂O₃) manufactured by Toshiba Barotini K.K. in the same manner as in Example 5, and the eluted amount of boron thus measured was 718 ppm of a sample mass amount. The HSC-110 used had an average particle size of 11.4 µm as measured by a laser scattering type particle size measuring apparatus and had a true density of 1.14 g/cm³ as measured by a dry type automatic densimeter.

The hollow glass microspheres of the present invention have a small particle size and a low density, and when they are used as a filler for a composite material, they are quite satisfactorily used particularly for use of requiring a smooth surface, use of requiring a low dielectric constant, and use of requiring a composite material having a restricted thickness, and can provide a satisfactory lightening effect, a heat insulating effect and an effect of lowering dielectric constant depending on an aimed use.

Also, since they comprise an aluminosilicate glass composition containing no alkali metal or substantially no alkali metal, they provide a high heat resistance, an excellent chemical durability without eluting a substantial amount of boron, and a satisfactory adhesiveness with resin.

Thus, they are excellent particularly as a resin filler for SMC of an outer decorating plate of an automobile and also as a filler for a resist material or an insulating layer material employed between layers of a multilayer substrate. Further, they can be quite satisfactorily used for various fields and uses, as a lightening filler for cement, mortal, synthetic wood, a low melting metal or alloy of aluminum or magnesium, and a paint, a heat insulating lightening filler for building materials or latex, a filler for sensitizing an explosive compound, a filler for an electric insulating layer, a sound-proofing filler, a cosmetics filler, a filter material, a blast media, a spacer and the like.

Also, according to the process of the present invention, hollow glass microspheres can be efficiently and industrially produced as compared with a production method using conventional starting materials.

The entire disclosures of Japanese Patent Application No. 2000-163352 filed on May 31, 2000 and Japanese Patent Application No. 2000-208295 filed on July 10, 2000 including specifications, claims and summaries are incorporated herein by reference in their entireties.

## Claims

1. A hollow glass microsphere having an average particle size of at most 15 µm based on volume, a maximum particle size of at most 30 µm and an average particle density of from 0.1 to 1.5 g/cm³, which has a glass composition consisting essentially of the following components by mass%:
| | |
|---|---|
| SiO₂ | 50.0-90.0%, |
| Al₂O₃ | 10.0-50.0%, |
| B₂O₃ | 0-12.0%, |
| Na₂O+K₂O+Li₂O | 0-1.0%, |
| CaO | 0-10.0%, |
| MgO | 0-10.0%, |
| BaO+SrO | 0-30.0%. |

2. The hollow glass microsphere according to Claim 1, wherein a boron concentration in the glass composition is at least 3 mass% as B₂O₃ and an eluted amount of boron measured by the following method is at most 300 ppm of a sample mass amount:
Method for measuring an eluted amount of boron: 200 cm³ of ethanol and 200 cm³ of distilled water are added to 12.5 g of a sample, and the resultant mixture was stirred at 80°C for 1 hour, and a solid content is filtrated, and a boron amount dissolved in a filtrate is determined, and the eluted amount is expressed by a proportion to a sample mass amount.

3. A method for producing a hollow glass microsphere, which comprises adding a combustible liquid to glass starting materials containing a foaming component, preparing a slurry of glass starting materials having an average particle size of at most 3.0 µm by wet-pulverizing, converting the slurry into liquid droplets containing the starting materials, and heating the liquid droplets to prepare hollow glass microspheres having an average particle size of at most 15 µm based on volume, a maximum particle size of at most 30 µm and an average particle density of from 0.1 to 1.5 g/cm³ and consisting essentially of the following glass composition:
| | |
|---|---|
| SiO₂ | 50.0-90.0%, |
| Al₂O₃ | 10.0-50.0%, |
| B₂O₃ | 0-12.0%, |
| Na₂O+K₂O+Li₂O | 0-1.0%, |
| CaO | 0-10.0%, |
| MgO | 0-10.0%, |
| BaO+SrO | 0-30.0%. |

4. The method for producing a hollow glass microsphere according to Claim 3, wherein a material generating water vapor, carbonic acid gas, sulfur oxide gas or nitrogen oxide gas by heating is added to the glass starting materials.

5. The method for producing a hollow glass microsphere according to Claim 3 or 4, wherein the combustible liquid is at least one member selected from the group consisting of alcohols selected from methanol, ethanol and isopropyl alcohol, ethers, kerosine, gas oil and heavy oil.

6. The method for producing a hollow glass microsphere according to any one of Claims 3 to 5, wherein a concentration of the glass starting materials in the slurry is from 5 to 50 wt%.

7. The method for producing a hollow glass microsphere according to any one of Claims 3 to 6, wherein the recovered hollow glass microspheres are subjected to flotation-separating treatment with water or alcohol.

8. The method for producing a hollow glass microsphere according to any one of Claims 3 to 7, wherein the recovered hollow glass microspheres are classified by a classifying treatment.

9. The method for producing a hollow glass microsphere according to any one of Claims 3 to 8, wherein a water slurry of recovered powder or the slurry recovered by flotation-separating method is subjected to centrifugal filtration, filtration under reduced pressure, or pressure filtration to separate solid and liquid, and washing is carried out by continuously supplying a washing water to a filter cake to remove salts.

10. The method for producing a hollow glass microsphere according to any one of Claims 3 to 9, wherein a filtration cake obtained by the solid-liquid separation is diluted with water again to prepare a slurry, and the slurry is fully stirred and subjected to filtration treatment repeatedly from one to several times to remove residual salts and impurities.
